# EUROPÄISCHE PATENTANMELDUNG

(11) **EP 3 627 262 A1**
(43) Veröffentlichungstag der Anmeldung: **25.03.2020**
(21) Anmeldenummer: 18195130.2
(22) Anmeldetag: 18.09.2018
(51) Int. Cl.: G05B 23/02

(54) **VERFAHREN UND ASSISTENZSYSTEM ZUR PARAMETRISIERUNG EINES ANOMALIEERKENNUNGSVERFAHRENS**

(71) Anmelder: Siemens Aktiengesellschaft, 80333 München (DE)
(72) Erfinder: Kehrer, Johannes, 81829 München (DE); Weber, Stefan Hagen, 81927 München (DE); Paulitsch, Christoph, 76137 Karlsruhe (DE)

(57) **Zusammenfassung**

Verfahren zur Parametrisierung eines Anomalieerkennungsverfahrens, das basierend auf einer Vielzahl von Sensordatenpunkten ein dichtebasiertes Clusterverfahren durchführt, umfassend
a) Abbilden (S10) eines jeden Sensordatenpunkts (SP1, SP2, SP3) in einem Datenraum in einen Pixeldatenpunkt (PP1, PP2, PP3) in einem Pixelraum,
b) Nachbilden (S11) mindestens einer Operation des dichtebasierten Clusterverfahrens im Datenraum durch mindestens eine Pixeloperation im Pixelraum,
c) Empfangen (S12) von mindestens einem Parameterwert für jeden Parameter des dichtebasierten Clusterverfahrens,
d) Anwenden (S13) der mindestens einen Pixeloperation entsprechend den Parameterwerten auf die Pixeldatenpunkte (PP1, PP2, PP3),
e) Ausgeben (S14) eines Clusterergebnisses in visueller Form im Pixelraum, und
f) Bereitstellen (S16) der empfangenen Parameterwerte für das Anomalieerkennungsverfahren, sowie
eine Assistenzvorrichtung (80) zur Parametrisierung einer Anomalieerkennungsvorrichtung (90), die das Anomalieerkennungsverfahren durchführt.

## Beschreibung

Die Erfindung betrifft ein Verfahren, ein Assistenzsystem sowie ein Computerprogrammprodukt zur Parametrisierung eines Anomalieerkennungsverfahrens, das basierend auf einer Vielzahl von Sensordatenpunkten ein dichtebasiertes Clusterverfahren in Echtzeit approximiert.

Eine datenbasierte Anomalieerkennung wird in Industrieanlagen dazu eingesetzt, unerwünschte oder gefährliche Betriebszustände von Maschinen oder sonstigen Komponenten der Anlage frühzeitig zu erkennen und rechtzeitig, beispielsweise durch Abschaltung oder Reparatur, darauf reagieren zu können.

Beispiele für Anomalien in Industrieanlagen, die anhand von meist durch Sensoren aufgenommene Daten erkannt werden sollen, sind ungewollte Produktionsminderungen, verschleißbedingte Gerätefehler, Abnutzungserscheinungen, Fehleinstellungen von Geräten, aber auch Nachfragerückgänge, Produktionsrückgänge oder Qualitätseinbußen.

Technische Verfahren zur Anomalieerkennung basieren üblicherweise auf einer bestimmten Parametrisierung, also der Auswahl von Eingangsparametern, der eingesetzten Algorithmen. Je besser die Abgrenzung von einem normalen zu einem anormalen Verhalten ist, desto besser kann ein regelgerechter Betrieb sichergestellt und Kosten durch Anomalien vermieden werden.

Ein weit verbreitetes Verfahren zur Anomalieerkennung ist das Trainieren eines dichtebasierten Clustering-Algorithmus auf Daten, insbesondere Sensordaten aus dem regelgerechten Betrieb, also Daten ohne Anomalien. Dieses Verfahren ist sehr trennscharf, aber schwierig zu parametrisieren. Bei zweidimensionalen Daten können die Ergebnisse aus dem Clustering-Algorithmus zur Überprüfung in Form eines Streudiagramms visualisiert werden, in dem die Punkte entsprechend ihres Anomaliestatus beziehungsweise ihrer Zugehörigkeit zu einem Cluster eingefärbt sind.

Eine richtige Einstellung der Parameterwerte solcher Clustering-Algorithmen, im Weiteren auch kurz als Clusterverfahren bezeichnet, ist wichtig, aber auch sehr zeitaufwändig. Schon eine geringe Abweichung der Parameterwerte vom domänenspezifischen und benutzerabhängigen Optimum kann zu veränderter Clusterbildung und damit schlechteren Erkennungsraten führen.

Es sind automatisierte Verfahren bekannt, welche Vorschläge zu einer initialen Parametrisierung eines dichtebasierten Clustering-Algorithmus liefern. Solche automatisierten Verfahren haben den Nachteil, dass die Parametrisierung aus einer Regel resultiert, welche das Optimum für einen konkreten Fall nur annähert, und keine aktuellen Informationen, wie zum Beispiel Kontext- und Domänenwissen eines Benutzers, berücksichtigt. Der Nutzer sollte möglichst auch verstehen, wie das automatisierte Verfahren zur Parameterbestimmung funktioniert und die Parameter bildet.

Des Weiteren muss ein Nutzer eines Clusterverfahrens, der den zugrundeliegenden Clustering-Algorithmus nicht im Detail nachvollziehen kann, trotzdem verstehen können, wie sich Änderungen der Parameterwerte des Algorithmus auf das Clusterergebnis auswirken. Deshalb ist es notwendig, dass ein Nutzer manuell geeignete Parameterwerte einstellt beziehungsweise nachjustiert. Dazu werden mindestens einer oder mehrere der Parameterwerte geändert und der Clustering-Algorithmus mit den neuen Parameterwerten gestartet. Die Berechnung der Clusterzugehörigkeit durch den Clustering-Algorithmus ist sehr zeitintensiv. Abhängig von der Anzahl der zugrunde liegenden Datenpunkte dauert die Berechnung von Sekunden bis zu Stunden. Anschließend kann das Clusterergebnis beispielsweise durch Visualisierung oder ausgegebene Fehlermaße ausgewertet werden. Um ein brauchbares Clusteringergebnis zu erhalten, sind häufig mehrfache Parameteränderungen und Berechnung der jeweiligen Clusterergebnisse notwendig.

Es ist somit die Aufgabe der vorliegenden Erfindung zeitoptimiert und unter Einbeziehung von Domänenwissen eines Benutzers, die Festlegung von Parametern für eine Anomalieerkennung zu beschleunigen.

Die Aufgabe wird durch die in den unabhängigen Ansprüchen beschriebenen Maßnahmen gelöst. In den Unteransprüchen sind vorteilhafte Weiterbildungen der Erfindung dargestellt.

Gemäß einem ersten Aspekt betrifft die Erfindung ein Verfahren zur Parametrisierung eines Anomalieerkennungsverfahrens, das basierend auf einer Vielzahl von Sensordatenpunkten ein dichtebasiertes Clusterverfahren durchführt, umfassend
a) Abbilden eines jeden Sensordatenpunktes in einem Datenraum in einen Pixeldatenpunkt in einem Pixelraum,
b) Nachbilden mindestens einer Operation des dichtebasierten Clusterverfahrens im Datenraum durch mindestens eine Pixeloperation im Pixelraum,
c) Empfangen von mindestens einem Parameterwert für jeden Parameter des dichtebasierten Clusterverfahrens,
d) Anwenden der mindestens einen Pixeloperation entsprechend den empfangenen Parameterwert auf die Pixeldatenpunkte,
e) Ausgabe eines Clusterergebnisses in visueller Form im Pixelraum, und
f) Bereitstellen der empfangenen Parameterwerte als Parameter für das Anomalieerkennungsverfahren.

Die Bezeichnungen Clusteranalyse, Clusteranalyseverfahren, Clusteringverfahren und Clusterverfahren werden nachfolgend als Synonyme verwendet.
Durch das Abbilden der Sensordatenpunkte in den Pixelraum und das Nachbilden des Clusterverfahrens durch Pixeloperationen kann nicht nur ein Ergebnis des Clusterverfahrens schneller dargestellt werden, sondern das nachgebildete Clusterverfahren als solches kann schneller ausgeführt werden. Aufwändige Berechnungen der Cluster entsprechend dem tatsächlichen Clustering-Algorithmus werden durch graphische beziehungsweise visuelle Verfahren angenähert und ersetzt. Operationen im Pixelraum können durch leistungsstarke Hardware, wie beispielsweise Graphikkarten, sowie zeitoptimierte Algorithmen durchgeführt werden.

Ein Sensordatenpunkt umfasst mindestens zwei Kenngrößen, auch kurz als Größen bezeichnet, eines Gerätes, wie beispielsweise Leistung, Geschwindigkeit, Spannung, Strom, Drehzahl, Drehmoment, aber auch Stückzahl, Qualität, Anzahl oder Dauer, zu einem beispielsweise Zeitpunkt oder bei einem bestimmten Betriebsmodus eines Geräts oder einer Anlagenkomponente. In einem Datenraum liegen Sensordaten als Werte ohne sonstigen Bezug vor. Ein Pixeldatenpunkt in einem Pixelraum bezeichnet einen Bildpunkt, auch als Pixel bezeichnet, der einem Sensordatenpunkt zugeordnet ist. Eine Vielzahl von Pixel wiederum spannt einen Pixelraum, im zweidimensionalen Fall beispielsweise Bildpunkte einer visuellen Ausgabeeinheit, beispielsweise einem Bildschirm oder Display, auf.

In einer vorteilhaften Ausführungsform wird nach Ausgabe des Clusterergebnisses mindestens einer der Parameterwerte geändert und die Verfahrensschritte c), d) und e) werden mit dem mindestens einen geänderten Parameterwert erneut durchgeführt.

Dies hat den Vorteil Clusterergebnisse mit veränderten Parametern kurzfristig visualisieren, also bildlich berechnen und darstellen zu können. Eine solche zeitoptimierte Berechnung und Darstellung von Clusterergebnissen mit unterschiedlichen Parametern erlaubt ein einfaches Erkennen von Auswirkungen der Parameteränderung auf die resultierenden Clusterergebnisse. Ein Nutzer lernt somit den Clustering-Algorithmus zu verstehen, ohne ein tieferes Verständnis der technischen Implementierung haben zu müssen. Somit ist eine Parametereinstellung des eigentlichen dichtebasierten Clusterverfahrens angepasst an die technischen Gegebenheiten und ein Domänenwissen eines Fachmanns möglich.

In einer vorteilhaften Ausführungsform wird der Pixelraum durch ein zweidimensionales Koordinatensystem aufgespannt, wobei jeder Koordinate eine unterschiedliche Größe der Sensordatenpunkte zugeordnet ist.

In einem zweidimensionalen Pixelraum können vorzugsweise Größen, die eine Abhängigkeit voneinander aufweisen, einander gegenübergestellt werden. Beispiele von Größen, die den beiden Koordinaten zugeordnet sind, sind beispielsweise Leistung und Geschwindigkeit, Intensität und Verschleiß, Umsatz und Gewinn, Anzahl und Dauer. Bevorzugt sind auch Messgrößen, die miteinander multipliziert physikalisch eine Leistung ergeben, wie beispielsweise Spannung und Strom, Drehzahl und Drehmoment oder auch Durchfluss und Druck, um beispielsweise Regionen gleicher Leistung zu ermitteln. Bevorzugt sind auch Größen wie Werkzeugnummer oder Maximalstrom beziehungsweise Druck, die von einer weiteren gemeinsamen charakteristischen Größe abhängen, so dass sich klare Gruppen ergeben.

Die Bezeichnungen Cluster und Gruppe werden in diesem Dokument als Synonym verwendet und bezeichnet eine Ähnlichkeitsstruktur von ähnlichen Objekten.

In einer vorteilhaften Ausführungsform entspricht das Verhältnis der Ausdehnung der beiden Koordinaten zueinander jeweils dem Verhältnis der Wertebereiche der zugeordneten Größe der Sensordatenpunkte zueinander, wobei insbesondere zumindest ein Wertebereich normalisierte Sensordatenwerte umfasst, oder mindestens ein Wertbereich Sensordatenwerte entsprechend einer Verteilungsfunktion umfasst.

Dies erlaubt eine intuitive Darstellung. Durch eine Normalisierung der Sensordatenwerte und anschließende Zuordnung zu einer Koordinate wird ein Fehler bei einer anschließenden Clusterbildung reduziert. Bei einer ungleichmäßigen Verteilung der Datenpunkte kann durch die Anordnung der Datenpunkte gemäß einer Verteilungsfunktion eine gleichmäßigere Verteilung der Datenpunkte auf die Pixel erreicht werden.

In einer vorteilhaften Ausführungsform ist das Clusterverfahren ein dichtebasiertes räumliches Clusteranalyseverfahren mit Rauschen, das auch abgekürzt als DBSCAN bezeichnet wird.

Dies hat den Vorteil, dass ein sehr häufig verwendetes Clusteranalyseverfahren zeitoptimiert approximiert wird.

In einer vorteilhaften Ausführungsform ist ein Distanzwert ein erster Parameter des Clusterverfahrens und die minimale Anzahl von Sensordatenpunkten um ein Cluster zu bilden, ein zweiter Parameter des Clusterverfahrens.

Dies ermöglicht es, die Hauptparameter von dichtebasierten Clusteranalyseverfahren über das visuelle Verfahren zeitoptimiert anzuwenden, ein daraus resultierendes Clusterergebnis anzuzeigen und analysieren zu können.

In einer vorteilhaften Ausführungsform ist eine Ermittlung von Kernpunkten aus der Vielzahl von Sensordatenpunkten eine erste Operation des dichtebasierten Clusterverfahrens im Datenraum und diese erste Operation wird auf eine erste Pixeloperation im Pixelraum abgebildet, wobei die erste Pixeloperation für jeden Sensordatenpunkt, dem ein betrachteter Pixeldatenpunkt zugeordnet ist, überprüft, ob die Anzahl der Pixeldatenpunkte, die innerhalb eines Distanzwertes entsprechend des ersten empfangenen Parameterwerts um den betrachteten Pixeldatenpunkt angeordnet sind, gleich dem zweiten empfangenen oder größer als der zweite empfangene Parameterwert ist.

Durch das Ersetzen der ersten Operation des dichtebasierten Clusterverfahrens durch eine erste Pixeloperation im Pixelraum können graphische Verfahren zur Berechnung und Darstellung des Clusterergebnisses verwendet werden. Diese erfordern eine geringere Anzahl an Rechenschritten, skalieren beispielsweise lediglich linear statt quadratisch, und ermöglichen damit eine Durchführung in Echtzeit.

In einer vorteilhaften Ausführungsform wird die Anzahl der Pixeldatenpunkte innerhalb eines Distanzwertes entsprechend dem ersten empfangenen Parameter um den betrachteten Pixeldatenpunkt durch das Ermitteln aller Pixeldatenpunkte, die innerhalb eines Strukturelements angeordnet sind, ermittelt, wobei das Strukturelement zentriert um den betrachteten Pixeldatenpunkt angeordnet ist und die räumliche Ausdehnung des Strukturelements abhängig vom ersten empfangenen Parameterwert ist.

Durch die Verwendung eines Strukturelements kann die Pixeldatenoperation zur Ermittlung eines Kernpunktes sehr effizient durch die Verwendung von Operationen aus der Bildverarbeitung durchgeführt werden.

In einer vorteilhaften Ausführungsform ist eine Form des Strukturelements abhängig von einem in dem Clusterverfahren verwendeten Distanzmaß, insbesondere ist das Strukturelement für ein euklidisches Distanzmaß rund, das Strukturelement für ein Manhatten-Distanzmaß rautenförmig und das Strukturelement für ein Chebyshev-Distanzmaß quadratisch.

Dies hat den Vorteil, dass die Ermittlung von Kernpunkten und damit von Clustern im Pixelraum flexibel auf ein im dichtebasierten Clusterverfahren verwendetes Distanzmaß angepasst werden kann. Durch die unterschiedliche Form des Strukturelements werden die unterschiedlichen Distanzmaße approximiert.

In einer vorteilhaften Ausführungsform wird jeder Pixeldatenpunkt im Pixelraum abhängig von einer minimalen Distanz des Pixeldatenpunktes zu einem nächsten Kernpunkt in einer Farbe dargestellt.

Dies hat den Vorteil, dass nicht nur die Zugehörigkeit zu einem Cluster, sondern die räumliche Nähe bzw. der Abstand eines Pixeldatenpunktes zu einem Kernpunkt dargestellt wird. Dadurch kann noch deutlicher die Dichteverteilung der Sensordatenpunkte sichtbar gemacht werden und bei einer Analyse des visuell dargestellten Clusterergebnisses mindestens einer der Parameter entsprechend angepasst werden.

In einer vorteilhaften Ausführungsform wird eine Kontur eines Clusters angezeigt, in dem die Pixeldatenpunkte, die einen Abstand von einer Hälfte des ersten Parameterwertes, bevorzugt zusätzlich die Pixeldatenpunkte, die einen Abstand von einem Ganzen ersten Parameterwert von einem am nächsten gelegenen Kernpunkt aufweisen, farblich dargestellt werden.

Durch eine solche Kontur werden ermittelte Gruppen oder Cluster deutlich erkennbar und trennscharf voneinander abgegrenzt. Eine solche Kontur zeigt somit Datenpunkte gleichen Abstands von "äußeren" Kernpunkten des ermittelten Clusters an und werden auch als Isokontur bezeichnet. Eine weitere Isokontur mit dem Abstandswert von einem halben Parameterwert gibt eine mögliche weitere Trennlinie zwischen Clusterpunkten und beispielsweise als Rauschen beziehungsweise anormal angesehene Pixeldatenpunkte an. Durch eine Darstellung der Konturlinien kann insbesondere deutlich ein Einfluss von geänderten Parameterwerten auf die ermittelten Cluster sichtbar und somit für einen Nutzer auswertbar gemacht werden. Alle Pixeldatenpunkte außerhalb dieser beiden Konturen, die einem Sensordatenpunkt entsprechen, werden als Rauschen beziehungsweise anormal angesehen und separat in einer von den umliegenden Pixeln, denen kein Sensordatenpunkt zugeordnet ist, unterscheidbaren Farbe dargestellt.

In einer vorteilhaften Ausführungsform werden die Pixel, entsprechend einer Schummerung abhängig von einer räumlichen Verteilung der Kernpunkte im Pixelraum dargestellt. Die Schummerung erfolgt anhand der Beleuchtung mit einer imaginären Lichtquelle.

Dies hat den Vorteil, die Positionierung einzelner Pixeldatenpunkte in der Nähe von Clustergrenzen besser beurteilen zu können. Insbesondere kann ein Benutzer selbst den Grad des 3D-Effekts einstellen oder ihn automatisch anhand der relativen Anzahl von Datenpunkten in der Nähe der Kontur oder weiterer Kennwerte einstellen lassen.

In einer vorteilhaften Ausführungsform wird für mehr als zweidimensionale Sensordatenpunkte ein zweidimensionales Verfahren mit zwei vorgebbaren Größen zu einem ausgewählten Datenwert einer dritten Größe der Sensordatenpunkte durchgeführt und über eine Änderung des ausgewählten Datenwertes der dritten Größe eine Änderung des Clusterergebnisses des zweidimensionalen Verfahrens dargestellt.

Dies erlaubt es, eine dritte Größe in die graphische Berechnung und visuelle Darstellung des Clusterergebnisses einzubeziehen. Durch eine beispielsweise kontinuierliche, schrittweise Änderung der dritten Größe und entsprechenden kontinuierlichen Darstellung der entsprechenden Clusterergebnisse kann die Veränderung der Cluster abhängig von dieser dritten Größe sichtbar und somit von einem Nutzer beziehungsweise Experten analysiert und mindestens ein Parameterwert der eingegebenen ersten und zweiten Parameter angepasst werden. Die dritte Größe, die einer dritten Datendimension entspricht, kann somit durch eine Animation der zweidimensionalen Sensordaten anhand einer dritten Dimension dargestellt werden. Für eine gute Interpretierbarkeit durch einen Experten werden Zeitschritte oder Betriebszustände als dritte Dimension empfohlen.

Ein zweiter Aspekt der Erfindung betrifft eine Assistenzvorrichtung, das eine Parametrisierung eines Anomalieerkennungsverfahrens, insbesondere ausgeführt in einer Anomalieerkennungsvorrichtung (90), basierend auf einer Vielzahl von Sensordatenpunkten mittels eines dichtebasierten Clusterverfahrens durchführt, umfassend
a) eine Abbildungseinheit, die derart ausgebildet ist, jeden Sensordatenpunkt in einen Pixeldatenpunkt in einen Pixelraum zu übertragen,
b) eine Nachbildeeinheit, die derart ausgebildet ist, mindestens eine Operation des dichtebasierten Clusterverfahrens im Datenraum durch mindestens eine Pixeloperation im Pixelraum nachzubilden,
c) eine Eingabeeinheit, die derart ausgebildet ist, mindestens einen Parameterwert für jeden Parameter des dichtebasierten Clusterverfahrens zu empfangen,
d) eine Operationseinheit, die derart ausgebildet ist, mindestens eine Pixeloperation entsprechend den Parameterwerten auf die Pixeldatenpunkte anzuwenden,
e) eine Ausgabeeinheit, die derart ausgebildet ist, Clusterergebnisse im Pixelraum in visueller Form darzustellen, und
f) eine Bereitstellungseinheit, die derart ausgebildet ist, die empfangenen Parameterwerte als Eingangsparameter für das Anomalieerkennungsverfahren bereitzustellen.

Eine solche Assistenzvorrichtung, die mindestens einen Prozessor umfasst, ermöglicht es das Clusterergebnis nicht mehr im ursprünglichen Datenraum, sondern in einem Pixelraum zu berechnen. Die Laufzeit zur Berechnung des Clusterergebnisses ist somit nicht mehr abhängig von der Anzahl der Datenpunkte, sondern der Anzahl der Pixel, also der Auflösung der Visualisierung, sowie der gewählten Parameterwerte. Über die Wahl der Anzahl der Pixel kann zwischen Auflösung und Rechenzeit abgewogen werden. Dies kann den Ansatz speziell für große Datensätze enorm beschleunigen. Somit ist eine Berechnung von Clusterergebnissen in Echtzeit möglich.

In einer vorteilhaften Ausführungsform ist der Pixelraum durch eine Vielzahl von Pixeln mindestens eines Teilbereichs der Ausgabeeinheit, insbesondere eines Bildschirms, ausgebildet.

Ein Pixel bezeichnet einen Bildpunkt einer visuellen Ausgabeeinheit. Ein Pixel kann aber auch eine Gruppe von physikalischen Bildpunkten sein, wenn die Auflösung der Eingabeeinheit größer als die Auflösung der Pixeldatenpunkte im Pixelraum ist.

In einer vorteilhaften Ausführungsform sind die Eingabeeinheit und die Ausgabeeinheit als eine graphische Nutzerschnittstelle ausgebildet, die derart ausgebildet ist, ein graphisches Eingabeelement für mindestens einen Parameter darzustellen und darüber den entsprechenden Parameterwert auszuwählen und zu empfangen.

Dies ermöglicht eine einfache und intuitive Änderungs- beziehungsweise Eingabemöglichkeit der Parameter, die insbesondere bei gleichzeitiger Darstellung des Clusterergebnisses einen Zusammenhang zwischen den empfangenen Parametern und dem Clusterergebnis erfassbar macht.

In einem dritten Aspekt betrifft die Erfindung ein Computerprogrammprodukt umfassend ein nicht vorübergehendes computer-lesbares Medium, das direkt in einen Speicher eines digitalen Computers ladbar ist, umfassend Programmcodeteile, die dazu geeignet sind, die Schritte des beschriebenen Verfahrens durchzuführen.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Unter einem Prozessor kann im Zusammenhang mit der Erfindung beispielsweise ein Computer, eine Maschine oder eine elektronische Schaltung verstanden werden. Auch kann unter einem Prozessor ein virtualisierter Prozessor, der beispielsweise in einem durch viele Nutzer geteilten Server, auch als Cloud bezeichnet, ausgebildet sein. Eine jeweilige "Einheit", zum Beispiel die Abbildungseinheit oder Nachbildeeinheit, kann hardwaretechnisch und/oder auch softwaretechnisch implementiert sein. Bei einer hardwaretechnischen Implementierung kann die jeweilige Einheit als Vorrichtung oder als Teil einer Vorrichtung zum Beispiel als Computer, als Teil eines Computers wie beispielsweise eine Graphikkarte oder als Mikroprozessor ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Ein Computerprogrammprodukt kann beispielsweise als Speichermedium, wie zum Beispiel eine Speicherkarte, USB-Stick, CD-ROM, DVD oder auch in Form einer herunterladbaren Datei von einem Server in einem Netzwerk bereitgestellt oder geliefert werden.

Ausführungsbeispiele des erfindungsgemäßen Verfahrens sowie der Assistenzvorrichtung sind in den Zeichnungen beispielhaft dargestellt und werden anhand der nachfolgenden Beschreibung näher erläutert. Es zeigen:
- Figur 1: ein Ausführungsbeispiel des erfindungsgemäßen Verfahrens als Flussdiagramm;
- Figur 2: eine schematische Darstellung von Parametern eines dichtebasierten Clusterverfahrens;
- Figur 3: eine schematische Darstellung der Abbildung von Sensordatenpunkten in einem dreidimensionalen Datenraum in Pixeldatenpunkte eines zweidimensionalen Pixelraums;
- Figur 4: eine schematische Darstellung zur Ausdehnung und Einteilung einer Koordinate entsprechend einer Verteilungsfunktion der Sensordatenwerte;
- Figur 5: eine schematische Darstellung der erfindungsgemäßen ersten Pixeloperation;
- Figur 6: ein Ausführungsbeispiel eines durch das erfindungsgemäße Verfahren ausgegebenen Clusterergebnisses in visueller Form im Pixelraum;
- Figur 7: ein Ausführungsbeispiel einer erfindungsgemäßen Assistenzvorrichtung in Blockdarstellung; und
- Figur 8: ein Ausführungsbeispiel einer erfindungsgemäßen Ausgabeeinheit mit graphischen Parametereingabeelementen in schematischer Darstellung.

Einander entsprechende Teile sind in allen Figuren mit den gleichen Bezugszeichen versehen.

Um eine datenbasierte Anomalieerkennung, beispielsweise für eine industrielle Anlage beziehungsweise ein technisches Gerät durchzuführen, ist eine Auswahl von Eingabeparametern, die einen Cluster charakterisieren, in ein Clusterverfahren notwendig. Die Parameter können beispielsweise in eine Anomalieerkennungsvorrichtung eingegeben werden und die zu untersuchenden Sensordaten entsprechend den eingegebenen Parametern Cluster von Sensordatenpunkten ermittelt und das Ergebnis des Clusterverfahrens ausgegeben werden. Erst anhand des Clusterergebnisses kann abgeschätzt werden, ob die eingegebenen Parameter zu einem für den Anwendungsbereich sinnvollen Clusterergebnis führen. Ein erneutes Durchführen der Clusteranalyse mit geänderten Parametern ist somit mehrfach notwendig. Da die Zeit zur Ermittlung eines Clusterergebnisses, insbesondere bei einer großen Datenmenge zeitaufwändig ist, können die Parameter für das Clusterverfahren durch das nachfolgende Verfahren zeitoptimiert und bereits unter Einbeziehung von Expertenwissen ermittelt werden.

Dabei wird die Funktionsweise eines dichtebasierten Clusterverfahrens durch eine interaktive Visualisierung nachempfunden. Dies erfolgt annähernd in Echtzeit. Ein Benutzer interagiert also nicht mehr mit dem langsamen dichtebasierten Clusterverfahren, das eine Berechnung von Clustern anhand von Sensordatenpunkten in einem Datenraum durchführt, sondern direkt mit einem interaktiven, visuell dargestellten und mit Datenverarbeitungsmethoden aus dem Bildverarbeitungsbereich durchgeführten Verfahren, das eine Auswirkung von Parameterändern in einem dichtebasierten Clusterverfahren direkt und in Echtzeit approximiert.

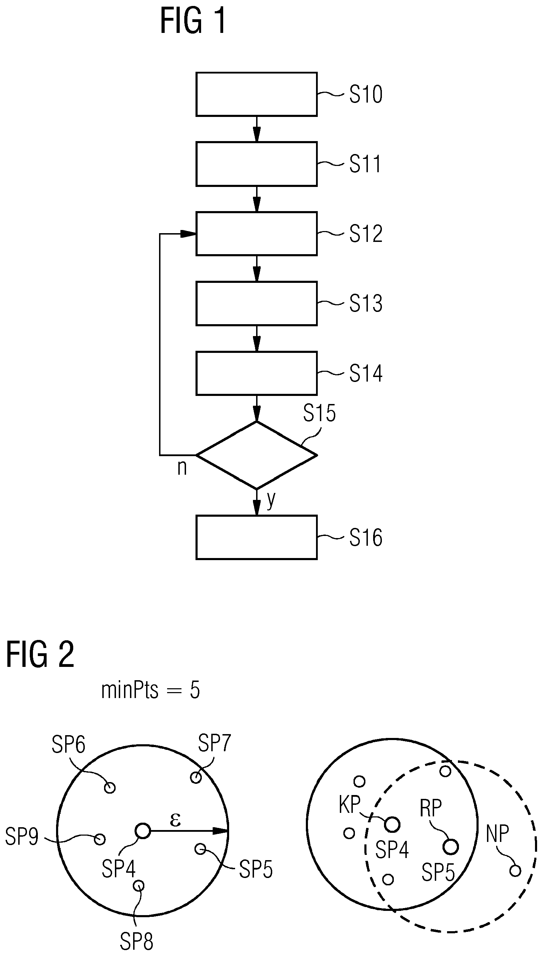

Dem Clusterverfahren liegen eine, insbesondere große, Anzahl von Datenpunkten, insbesondere Sensordatenpunkten, vor, für die ein Zusammenhang in Form einer Dichteverteilung von Datenpunkten in Gruppen, sogenannte Cluster, ermittelt werden soll. Figur 1 zeigt das Verfahren als Flussdiagramm. In einem ersten Verfahrensschritt S10 wird ein jeder Sensordatenpunkt in einem Datenraum in einen Pixeldatenpunkt in einem Pixelraum abgebildet.

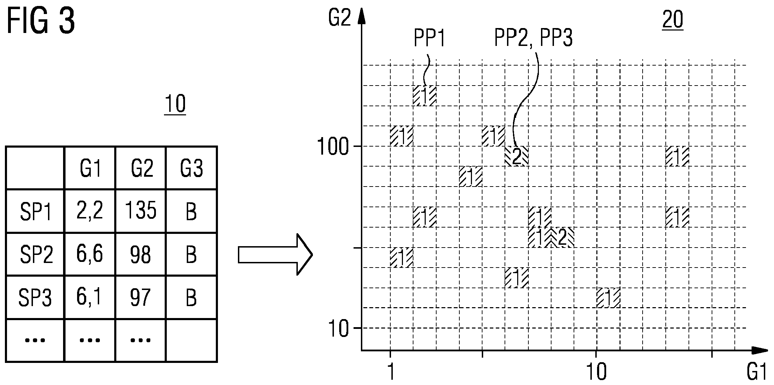

Figur 3 zeigt beispielhaft für einen dreidimensionalen Datenraum 10 Sensordatenpunkte SP1, SP2, SP3, die jeweils einen Wert für eine jeweils unterschiedliche Größe G1, G2, G3 aufweisen. Die Größe G1 könnte beispielsweise die Leistung, die Größe G2 beispielsweise die Geschwindigkeit angeben. G3 könnte eine vorbestimmte Zeit oder ein Betriebsmodus sein. Die Sensordatenpunkte werden hier in ein zweidimensionales Koordinatensystem mit den Ausdehnungen eines Pixelraums 20, beispielsweise von Bildpunkten einer visuellen Ausgabeeinheit, wie beispielsweise einem Bildschirm, abgebildet. Die Abbildung wird durch den Pfeil symbolisiert. Dazu werden alle Datenpunkte der Größen G1, G2 bei einem festen Wert der Größe G3, beispielsweise dem Wert B für die Clusteranalyse berücksichtigt. So wird beispielsweise der Sensordatenpunkt SP1 im Datenraum 10 auf einen Pixeldatenpunkt PP1 im Pixelraum 20 abgebildet. Entsprechend wird der Sensordatenpunkt SP2 auf den Pixeldatenpunkt PP2 abgebildet. Der Sensordatenpunkt SP3 wird auf den Pixeldatenpunkt PP3 abgebildet, der mit dem Pixeldatenpunkt PP2 zusammenfällt, da die Auflösung des Pixeldatenraums 20 keinen separaten Pixel für diesen Wert bereithält.

Das Verhältnis der Ausdehnung des Pixelraums 20, das heißt das Verhältnis der Koordinaten für die Größen G1 und G2 ist im gezeigten Beispiel gleich dem Verhältnis der Wertebereiche der Eingangsdaten. Im Idealfall ist die Skalierung der beiden Koordinaten identisch. Je größer die Abweichung der Skalierung ist, desto größer ist der Fehler bei einer anschließenden Ermittlung der Cluster. Daher ist bei großen Unterschieden der Wertebereiche vorab eine Normalisierung der Sensordatenpunkte vorzunehmen. Die Ermittlung der Cluster sollte dann auch auf die normalisierten Datenpunkte durchgeführt werden. Für jeden Pixel im Pixelraum 20 wird die Anzahl von Sensordatenpunkten berechnet, die auf diese Pixelpositionen abgebildet werden. Für die Pixelpositionen des Pixeldatenpunktes PP2 ist daher die Anzahl der darauf projizierten Sensordatenpunkte, hier also der Wert 2, vermerkt.

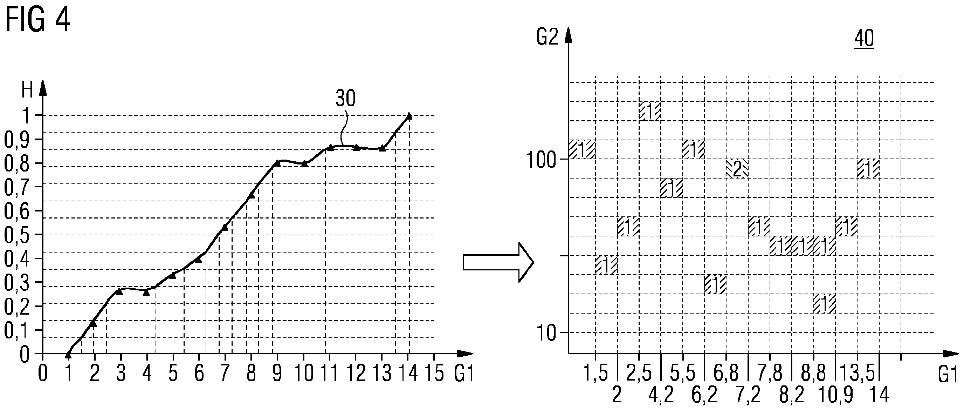

Um eine besonders gute Auflösung der Pixeldatenpunkte bei sehr unterschiedlicher Dichteverteilung der Sensordatenpunkte zu erreichen, kann ein Wertebereich von Sensordatenwerten entsprechend einer Verteilungsfunktion 30 eingeteilt werden. Figur 4 zeigt auf der linken Seite eine solche Verteilungsfunktion 30, bei der die Häufigkeit H, mit der ein Wert der Größe G1 vorhanden ist, über den Wertebereich der Größe G1 aufgetragen ist. Auf der rechten Seite von Figur 4 ist die Koordinate der Größe G1 des Pixelraums 40 entsprechend der Verteilungsfunktion 30 skaliert. Dabei werden die Abstände zwischen jeweils zwei blau markierten Werten von G1 auf gleiche Abstände der Koordinate G1 im Pixelraum 40 überführt. Dies hat jedoch den Nachteil, dass eine darauf basierte Clusterbestimmung von der üblichen Verteilung der Datenpunkte und somit von der üblichen bekannten Darstellung für den Domänenexperten abweicht. Eine Interpretation des Clusterergebnisses wird somit eventuell erschwert.

Im nächsten Verfahrensschritt S11, siehe Figur 1, wird nun mindestens eine Operation des dichtebasierten Clusterverfahrens im Datenraum durch mindestens eine Pixeloperation im Pixelraum nachgebildet. Ein sehr häufig verwendetes dichtebasiertes Clusterverfahren ist ein so genanntes dichtebasiertes räumliches Clusteranalyseverfahren mit Rauschen, kurz auch als DBSCAN bezeichnet. Dieses Clusterverfahren wird über zwei Parameter, einen Distanzwert ε sowie einen Schwellwert für die minimale Anzahl von Datenpunkten (minPts), die eine Gruppe beziehungsweise ein Cluster darstellen, gesteuert.

In Figur 2 sind diese Parameter und weitere Kenngrößen zur Clusterermittlung des DBSCAN-Clusterverfahrens schematisch dargestellt. Um eine dichte Region im Datenraum, also ein Cluster zu finden, wird für jeden Sensordatenpunkt SP4 überprüft, wie viele andere Sensordatenpunkte in einem Abstand kleiner dem vorgegebenen Distanzwert ε vorhanden sind. Im linken Bereich von Figur 2 sind mehrere Sensordatenpunkte Sp4- SP9 durch Punkte dargestellt, der betrachtete Sensordatenpunkt SP4 ist mit einer stärkeren Kontur markiert. Der Pfeil zeigt einen Abstand ε, der dem vorgegebenen ersten Parameter entspricht und eine Distanz angibt. Ist die Anzahl der Sensordatenpunkte in der Umgebung des betrachteten Sensorpunktes SP4 gleich oder größer als der vorgegebene zweite Parameter minPts, der einen Schwellwert für die Anzahl der benachbarten Datenpunkte angibt, so ist der betrachtete Sensordatenpunkt SP4 ein Kernpunkt eines Clusters. Ist der Schwellwert beispielsweise auf die Anzahl von fünf Datenpunkten festgelegt, so ist der Sensordatenpunkt SP4 ein Kernpunkt KP. Alle Sensordatenpunkte, welche selbst nicht Kernpunkte sind, die jedoch innerhalb der Distanz ε zu einem existierenden Kernpunkt liegen, werden als Randpunkte bezeichnet. Der Sensordatenpunkt SP5 auf der rechten Seite von Figur 2 ist beispielsweise ein Randpunkt, da er einen geringeren Abstand als die vorgegebene Distanz ε zum Kernpunkt SP4 aufweist, selbst aber kein Kernpunkt ist, da lediglich vier Datenpunkte in einem Abstand ε liegen. Ein Punkt NP wird als Rauschpunkt bezeichnet, wenn er einen größeren Abstand als der vorgegebene erste Parameter ε zum nächsten Kernpunkt aufweist.

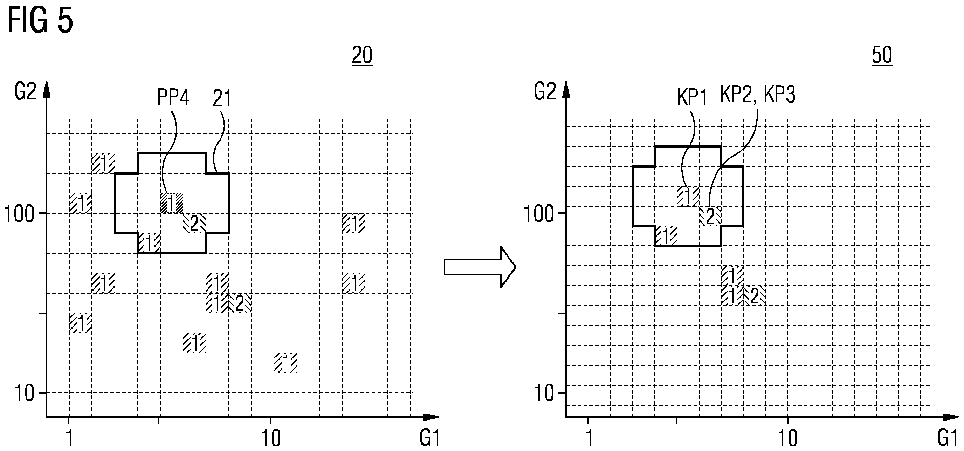

Das Bestimmen von Kernpunkten und Clustern wird nun im Pixelraum durch eine Pixeloperation nachgebildet. Figur 5 zeigt auf der linken Seite die aus Figur 3 bekannte Darstellung der Sensordatenwerte in einem Pixelraum 20. Die Darstellung entspricht einem zweidimensionalen Histogramm, das zusätzlich zu jedem Pixel die Anzahl der Sensordatenpunkte, die durch den gleichen Pixel dargestellt werden, umfasst. Die vorher beschriebene erste Operation des dichtebasierten Clusterverfahrens im Datenraum wird nun auf eine erste Pixeloperation im Pixelraum abgebildet. Die erste Pixeloperation überprüft für jeden Sensordatenpunkt, dem ein betrachteter Pixeldatenpunkt PP4 zugeordnet ist, ob die Anzahl der Pixeldatenpunkte, die innerhalb eines Distanzwertes ε entsprechend einem ersten Parameterwert um den betrachteten Pixeldatenpunkt PP4 angeordnet sind, größer als der zweite Parameterwert, nämlich die minimale Anzahl von Datenpunkten minPts in einem Cluster ist.

In einer Implementierung dieser Operation wird beispielsweise für jeden Eintrag im 2D-Histogramm, siehe Pixelraum 20 der einen Wert ungleich Null aufweist, überprüft, ob die Anzahl der Pixeldatenpunkte innerhalb der Distanz ε größer dem Schwellwert der Anzahl von Punkten minPts ist. Dazu wird beispielsweise der Pixeldatenpunkt PP4 als betrachteter Pixeldatenpunkt untersucht, indem ein Strukturelement 21 der Ausdehnung entsprechend dem ersten Parameter ε verwendet wird. Ist dies erfüllt, wird der Punkt PP4 als Kernpunkt KP in eine separate Ergebnismatrix 50, siehe rechte Seite von Figur 5, gespeichert. Das Fallen eines Pixeldatenpunkts in ein Strukturelement 21 kann durch günstige Implementierung zeitoptimiert überprüft werden. Insbesondere eine Implementierung durch Zählen der Anzahl von Datenpunkten in der Nachbarschaft zu einem betrachteten Pixeldatenpunkt PP4 aus dem 2D-Histogramm 20 ermöglicht eine schnelle Implementierungsausführung.

Im nächsten Verfahrensschritt S12 des erfindungsgemäßen Verfahrens, siehe Figur 1, werden nun mindestens ein Parameterwert für jeden Parameter des dichtebasierten Clusterverfahrens empfangen. Somit sind nun für den bereits beschriebenen Vorgang die Größe des Strukturelements ε sowie der Schwellwert für die Anzahl von Pixeldatenpunkten minPts, die ein Cluster bilden, festgelegt. Als ein weiterer Parameter kann ein Distanzmaß, das im Clusterverfahren angewandt werden soll, festgelegt werden. Entsprechend einem solchen Distanzmaß wird ein unterschiedliches Strukturelement 21 in der Pixeloperation verwendet. Für ein euklidisches Distanzmaß wird ein rundes Strukturelement 21 verwendet. Für ein Manhatten-Distanzmaß wird ein rautenförmiges Strukturelement, für ein Chebyshev-Distanzmaß wird ein quadratisches Distanzmaß verwendet. Die beschriebene Pixeloperation wird nun in Verfahrensschritt S13, siehe Figur 1, entsprechend den empfangenen Parameterwerten auf die Pixeldaten angewendet und in Schritt S14 das Clusterergebnis in visueller Form im Pixelraum ausgegeben.

Für das Ausgeben (S14) der Clusterergebnisse wird nach dem Ermitteln der Kernpunkte KP1, KP2, KP3 der Cluster für jedes Pixel im Pixelraum 20 die minimale Distanz zum nächsten Kernpunkt KB aus der Ergebnismatrix 50 berechnet. Ein resultierendes Distanzfeld kann sehr effizient beispielsweise durch einen Algorithmus von Meijster et al. berechnet werden, der in "A General Algorithm for Computing Distance Transforms in Linear Time," in Mathematical Morphology and its Applications to Image and Signal Processing, Seiten 331-340, Springer, 2000, beschrieben ist. Für eine visuelle Darstellung wird die berechnete minimale Distanz zu den Kernpunkten aus dem Distanzfeld in Farbe abgebildet. Somit wird jeder Pixeldatenpunkt im Pixelraum abhängig von einer minimalen Distanz zu einem nächsten Kernpunkt in einer unterschiedlichen Farbe dargestellt. Bevorzugt wird eine divergierende Farbpalette verwendet und abhängig vom Abstand eines Pixels vom nächsten Kernpunkt die Pixelfarbe entsprechend einem Farbgradienten unterschiedlich gewählt. Die Kernpunkte selbst werden im Ergebnis nicht mehr separat dargestellt und sind durch die Farbpalette erkennbar. Die Farbpalette wird für das gesamte Ergebnisbild bevorzugt einheitlich definiert.

Um den Rand beziehungsweise die Grenzen eines Clusters deutlich erkennen zu können, wird eine Eingrenzung berechnet und eingezeichnet. Hierfür werden Isokonturen auf dem Distanzfeld für einen Abstand von einem Ganzen des ersten Parameterwertes ε und bevorzugt eine weitere Isokontur mit dem Abstand von der Hälfte des ersten Parameterwertes ε/2 berechnet. Ein Benutzer kann somit zwischen Kernpunkten, die innerhalb der Isokontur mit einem Abstand von der Hälfte des ersten Parameterwertes ε/2 liegen und Randpunkten des Clusters unterscheiden. Alle Punkte, die also durch eine Abbildung eines Sensordatenpunktes definiert sind, die außerhalb dieser beiden Konturen liegen, werden als Rauschen beziehungsweise anormal angesehen und bevorzugt in einer Farbe, die sich von den sonstigen Pixeln unterscheidet, separat dargestellt.

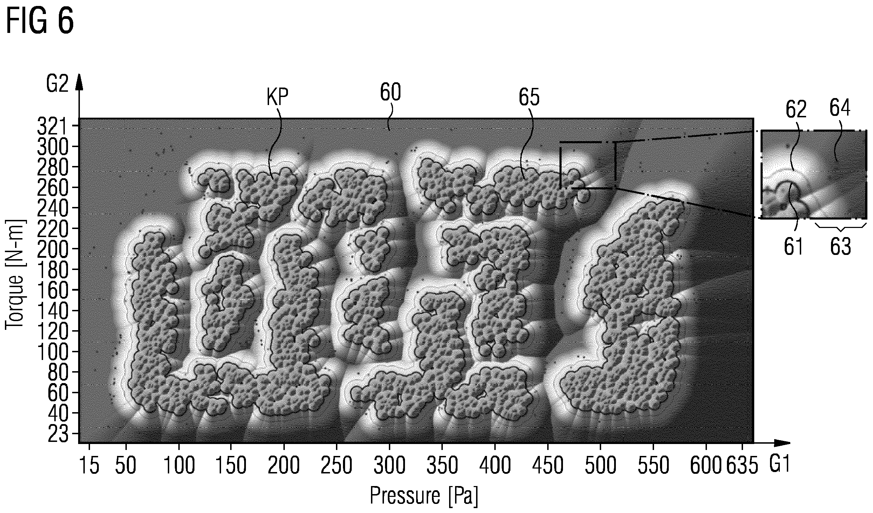

Eine visuelle Darstellung 60 des Clusterergebnisses ist in Figur 6 dargestellt. In einer farblichen Darstellung ist beispielsweise ein Kernpunkt KP in grüner Farbe dargestellt, die Pixel entsprechend ihrem Abstand zum nächsten Kernpunkt, werden beispielsweise in einer graduellen Farbskala von grün nach weiß dargestellt.

Im rechts neben der visuellen Darstellung des Clusterergebnisses 60 dargestellten Ausschnitt ist ein Bereich eines Cluster 65 vergrößert dargestellt. Der farbliche Verlauf außerhalb des Clusters 65, siehe Bereich 63, zeigt eine Schummerung, die abhängig von einer räumlichen Verteilung der Kernpunkte im Pixelraum dargestellt wird. Die Kontur 61 mit einem Abstand und einem halben empfangenen Parameterwert ε/2 ist dabei deutlicher sichtbar als die Isokontur 62, die einen Abstand eines ganzen ersten Parameterwerts ε angibt. Rauschpunkte 64 sind wiederum farblich abgehoben dargestellt.

Liegen auf beiden Seiten nahe der Kontur 61 ähnlich viele Pixeldatenpunkte vor, ist ein besonders starker Höheneffekt erzeugt durch die Schummerung wünschenswert. Dadurch wird die Zuverlässigkeit der Grenze verdeutlicht. Ist der Unterschied der Anzahl der Pixeldatenpunkte auf beiden Seiten der Kontur hoch, kann die Unsicherheit der Kontur an dieser Stelle durch einen schwächeren Höheneffekt verdeutlicht werden. Ebenfalls wird ein Genauigkeitswert für die Zuverlässigkeit angegeben

Nach einer Ausgabe des Clusterergebnisses kann mindestens einer der Parameterwerte, bevorzugt über eine graphische Nutzerschnittstelle geändert werden, siehe Verfahrensschritt S15 in Figur 1. Ist dies der Fall, wird der geänderte Parameterwert im Verfahrensschritt S12 im Verfahren empfangen und die Verfahrensschritte des Anwendens S13 der Pixeloperation erneut durchgeführt und ein Clusterergebnis basierend auf den geänderten Parameterwerten ausgegeben, siehe Verfahrensschritt S15. Diese wiederholte Anwendung der Pixeloperationen ist durch den Pfeil n symbolisiert. Sind keine weiteren Parameteränderungen gewünscht, siehe Pfeil y, werden im Verfahrensschritt S16 die letzten empfangenen Parameterwerte ε und minPts dem Anomalieerkennungsverfahren, das das dichtebasiertes Clusterverfahren mit den Sensordatenpunkten im Datenraum beispielsweise in einer Anomalieerkennungsvorrichtung ausführt, bereitgestellt.

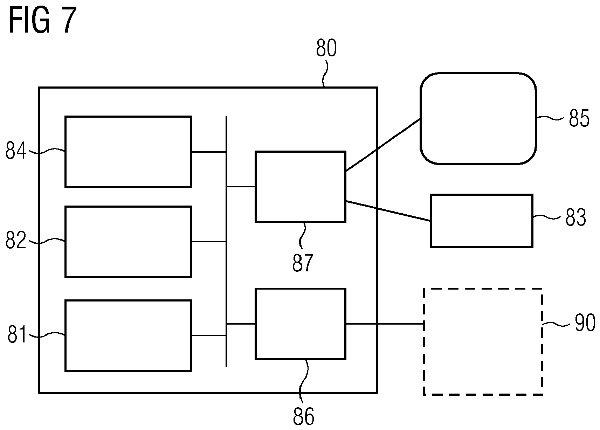

Figur 7 zeigt eine Assistenzvorrichtung 80, die das beschriebene Verfahren ausführt. Die Assistenzvorrichtung 80 umfasst eine Abbildungseinrichtung 81, die derart ausgebildet ist, jeden Sensordatenpunkt in einen Pixeldatenpunkt in einem Pixelraum zu übertragen, eine Nachbildeeinheit 82, die derart ausgebildet ist, mindestens eine Operation des dichtebasierten Clusterverfahrens im Datenraum durch mindestens eine Pixeloperation im Pixelraum nachzubilden, sowie eine Operationseinheit 84, die derart ausgebildet ist, mindestens eine Pixeloperation entsprechend den empfangenen Parameterwerten auf die Pixeldatenpunkte anzuwenden. Die Assistenzvorrichtung 80 umfasst des Weiteren eine Bereitstellungseinheit 86, die die empfangenen Parameterwerte als Eingangsparameter für ein Anomalieerkennungsverfahren im Datenraum einer Anomalieerkennungsvorrichtung 90 bereitstellt. Über diese Bereitstellungseinheit 86 kann ebenfalls die zu betrachtende gesamte Sensordatenmenge in das Assistenzsystem geladen beziehungsweise dort empfangen und gespeichert werden. Das Assistenzsystem 80 umfasst des Weiteren eine Eingabeeinheit 83 und eine visuelle Ausgabeeinheit 85, die bevorzugt als eine graphische Nutzerschnittselle ausgebildet sind.

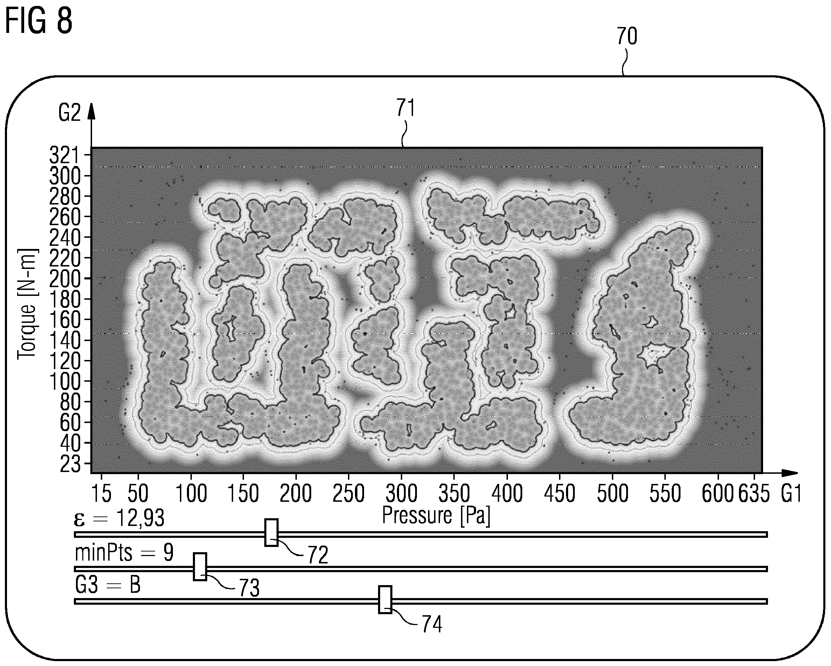

Figur 8 zeigt eine Ausgabeeinheit beziehungsweise die darauf dargestellte graphische Nutzerschnittstelle 70. In Bereich 71 ist dabei ein Clusterergebnis dargestellt. Darunter sind für den ersten und zweiten Parameter ε, minPts jeweils ein graphisches Eingabeelement 72, 73 angezeigt. Das graphische Eingabeelement 72, 73 kann beispielsweise jeweils als ein Schieberegler dargestellt sein, über den der erste und/oder der zweite Parameter ε, minPts geändert und als Eingabe für die Pixeloperation an die Operationseinheit 84 bereitgestellt werden. Eine Neuberechnung der Cluster erfolgt automatisch nach einer Parameteränderung.

Zur Erweiterung der Clusteranalyse auf mehr als zweidimensionale Sensordaten können beispielsweise Aggregationsverfahren auf zwei Dimensionen wie zum Beispiel selbstorganisierende Karten angewendet werden. Erfindungsgemäß wird eine dritte oder weitere Datendimension bzw. eine entsprechende Größe G3 durch eine Animation der zweidimensionalen Clusteranalyse anhand eines jeweils unterschiedlichen Sensordatenwertes B der dritten Größe G3 dargestellt. Hierbei kann auf eine geeignete Wahl der dritten Dimension G3 eventuell durch eine vorhergehende Aggregation mehrerer Datendimensionen Rücksicht genommen werden.

Mit einem weiteren graphischen Eingabeelement, beispielsweise einem weiteren Schieberegler 74, kann ein Datenwert der dritten Größe G3 eingegeben werden. Beispielsweise kann das Clusterverfahren für sukzessiv geänderte Werte der dritten Größe durchgeführt und die visuelle Darstellung der resultierenden Clusterergebnisse als Animation dargestellt werden. Insbesondere können für die dritte Datendimension verändernde Betriebsbedingungen wie zum Beispiel Stillstand, Hochfahren, Teillastbetrieb, Volllastbetrieb, Herunterfahren gewählt werden, so dass Vergleiche der angelernten "Gut- und Schlechtbereiche", die durch Punkte innerhalb der Cluster beziehungsweise außerhalb der Cluster gekennzeichnet sind, zwischen verschiedenen Betriebsbedingungen möglich sind. Somit werden gerade nicht die bekannten, gewollten Betriebsbedingungsänderungen als Anomalie erkannt. Veränderungen von Pixeldatenpunkten bei unterschiedlichen Betriebsbedingungen, also einer unterschiedlichen dritten Dimension von Größen, können anhand von Trajektorien beispielsweise von Kernpunkten oder ausgewählten Punkten der Konturlinien 61, 62 dargestellt werden.

Durch das beschriebene Verfahren und die beschriebene Vorrichtung können geeignete Parameterwerte für eine erste Analyse im Datenraum durch die graphische approximierte Durchführung des Clusterverfahrens in einen Pixelraum zeitoptimiert ermittelt und durch Expertenwissen vorgeprüft werden. Durch die Durchführung des Clusterverfahrens in Echtzeit und eine einfache Änderung der Parameter kann der Einfluss der Parameter auf das Clusterergebnis anschaulich dargestellt werden und auch einem Nichtexperten das Verhalten des Clusterverfahrens abhängig von den Eingabeparametern aufgezeigt werden. Somit kann das zeitaufwändige datenbasierte Clusterverfahren im Datenraum nur für voruntersuchte und sinnvoll erachtete Parameterwerte durchgeführt werden und somit zu einem zeitoptimierten Anomalieerkennungsprozess beitragen. Über ein geeignetes Abbild beziehungsweise Mapping der Größen auf den Pixelraum können Rechenzeit gegenüber Auflösung gegeneinander abgewogen werden, so dass zum Beispiel ein Anlagenbediener schnell einen groben Überblick erhält, der dann beim Auftreten von Anomalien durch einen Instandhalter mit einer längerdauernden Analyse im Detail untersucht werden kann.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zur Parametrisierung eines Anomalieerkennungsverfahrens, das basierend auf einer Vielzahl von Datenpunkten, insbesondere Sensordatenpunkten, ein dichtebasiertes Clusterverfahren durchführt, umfassend
a) Abbilden (S10) eines jeden Sensordatenpunkts (SP1, SP2, SP3) in einem Datenraum in einen Pixeldatenpunkt (PP1, PP2, PP3) in einem Pixelraum,
b) Nachbilden (S11) mindestens einer Operation des dichtebasierten Clusterverfahrens im Datenraum durch mindestens eine Pixeloperation im Pixelraum,
c) Empfangen (S12) von mindestens einem Parameterwert für jeden Parameter des dichtebasierten Clusterverfahrens,
d) Anwenden (S13) der mindestens einen Pixeloperation entsprechend den empfangenen Parameterwerten auf die Pixeldatenpunkte (PP1, PP2, PP3),
e) Ausgeben (S14) eines Clusterergebnisses in visueller Form im Pixelraum, und
f) Bereitstellen (S16) der empfangenen Parameterwerte für das Anomalieerkennungsverfahren.

2. Verfahren nach Anspruch 1, wobei nach Ausgabe des Clusterergebnisses mindestens einer der Parameterwerte geändert wird (S15) und die Verfahrensschritte c), d) und e) mit dem mindestens einen geänderten Parameterwert erneut durchgeführt werden.

3. Verfahren nach einem der vorangehenden Ansprüche, wobei der Pixelraum durch ein zweidimensionales Koordinatensystem aufgespannt wird, wobei jeder Koordinate eine unterschiedliche Größe (G1, G2) der Sensordatenpunkte (SP1, SP2, SP3) zugeordnet ist.

4. Verfahren nach Anspruch 3, wobei das Verhältnis der Ausdehnung der beiden Koordinaten zueinander jeweils dem Verhältnis der Wertebereiche der zugeordneten Größe (G1, G2) der Sensordatenpunkte zueinander entspricht, oder mindestens ein Wertebereich normalisierte Sensordatenwerte umfasst oder mindestens ein Wertebereich Sensordatenwerte entsprechend einer Verteilungsfunktion (30) umfasst.

5. Verfahren nach einem der vorangehenden Ansprüche, wobei das Clusterverfahren ein dichtebasiertes räumliches Clusteranalyseverfahren mit Rauschen (DBSCAN) ist.

6. Verfahren nach Anspruch 5, wobei
ein Distanzwert (ε) ein erster Parameter des Clusterverfahrens und die minimale Anzahl (minPts) von Sensordatenpunkten (SP1, SP2, SP3) um ein Cluster zu bilden, ein zweiter Parameter des Clusterverfahrens ist.

7. Verfahren nach Anspruch 5 oder 6, wobei eine Ermittlung von Kernpunkten (KP) aus der Vielzahl von Sensordatenpunkten (SP1, SP2, SP3) eine erste Operation des dichtebasierten Clusterverfahrens im Datenraum ist und diese erste Operation auf eine erste Pixeloperation im Pixelraum abgebildet wird, wobei die erste Pixeloperation für jeden Sensordatenpunkt (SP1, SP2, SP3), dem ein betrachteter Pixeldatenpunkt (PP4) zugeordnet ist, überprüft, ob die Anzahl der Pixeldatenpunkte, die innerhalb eines Distanzwerts entsprechend dem ersten empfangenen Parameterwert um den betrachteten Pixeldatenpunkt (PP4) angeordnet sind, gleich dem zweiten empfangenen oder größer als der zweite empfangene Parameterwert ist.

8. Verfahren nach Anspruch 7, wobei die Anzahl der Pixeldatenpunkte innerhalb eines Distanzwerts entsprechend dem ersten empfangenen Parameter um den betrachteten Pixeldatenpunkt durch das Ermitteln aller Pixeldatenpunkte, die innerhalb eines Strukturelement (21) angeordnet sind, ermittelt wird, wobei das Strukturelement (21) zentriert um den betrachteten Pixeldatenpunkt (PP4) angeordnet ist, und die räumliche Ausdehnung des Strukturelements abhängig vom ersten empfangenen Parameterwert (ε) ist.

9. Verfahren nach Anspruch 8, wobei eine Form des Strukturelements (21) abhängig von einem in dem Clusterverfahren angewendeten Distanzmaß ist, insbesondere das Strukturelement (21) für ein Euklidisches Distanzmaß rund ist, das Strukturelement (21) für ein Manhattan Distanzmaß rautenförmig ist, das Strukturelement (21) für ein Chebyshev Distanzmaß quadratisch ist.

10. Verfahren nach einem der Ansprüche 6 bis 9, wobei jeder Pixeldatenpunkt (PP1, PP2, PP3) im Pixelraum abhängig von einer minimalen Distanz des Pixeldatenpunktes (PP1, PP2, PP3) zu einem nächsten Kernpunkt (KP) in einer Farbe dargestellt wird.

11. Verfahren nach einem der Ansprüche 6 bis 10, wobei eine Kontur (61, 62) eines Clusters anzeigt wird, indem die Pixeldatenpunkte (PP1, PP2, PP3), die einen Abstand von der Hälfte des ersten Parameterwerts (ε/2), bevorzugt zusätzlich die Pixeldatenpunkte, die einen Abstand von einem Ganzen ersten Parameterwert (ε) von einem am nächsten gelegenen Kernpunkt (KP) aufweisen, farblich dargestellt werden.

12. Verfahren nach einem der Ansprüche 6 bis 11, wobei die Pixel entsprechend einer Schummerung abhängig von einer räumlichen Verteilung der Kernpunkte im Pixelraum dargestellt werden.

13. Verfahren nach einem der Ansprüche 1 bis 3, wobei für mehr als zweidimensionale Sensordatenpunkte ein zweidimensionales Verfahren gemäß den Ansprüchen 4 bis 12 mit zwei vorgebbaren Größen (Dimensionen) zu einem ausgewählten Datenwert einer dritten Größe der Sensordatenpunkte durchgeführt wird und über eine Änderung des ausgewählten Datenwertes der dritten Größe eine Änderung des Clusterergebnisses des zweidimensionalen Verfahrens dargestellt wird.

14. Assistenzvorrichtung (80) zur Parametrisierung eines Anomalieerkennungsverfahrens, insbesondere ausgeführt in einer Anomalieerkennungsvorrichtung (90), basierend auf einer Vielzahl von Sensordatenpunkten mittels eines dichtebasierten Clusterverfahrens durchführt, umfassend
a) Abbildungseinheit (81), die derart ausgebildet ist, jeden Sensordatenpunkt (SP1, SP2, SP3) in einem Datenraum in einen Pixeldatenpunkt (PP1, PP2, PP3) in einem Pixelraum abzubilden,
b) Nachbildeeinheit (82), die derart ausgebildet ist, mindestens eine Operation des dichtebasierten Clusterverfahrens im Datenraum durch mindestens eine Pixeloperation im Pixelraum nachzubilden,
c) Eingabeeinheit (83), die derart ausgebildet ist, mindestens einen Parameterwert für jeden Parameter des dichtebasierten Clusterverfahrens zu empfangen,
d) Operationseinheit (84), die derart ausgebildet ist, mindestens eine Pixeloperation entsprechend den empfangenen Parameterwerten auf die Pixeldatenpunkte anzuwenden,
e) Ausgabeeinheit (85), die derart ausgebildet ist, Clusterergebnisse im Pixelraum in visueller Form auszugeben, und
f) Bereitstellungseinheit (86), die derart ausgebildet ist, die empfangenen Parameterwerte als Eingangsparameter für die Anomalieerkennungsverfahren bereitzustellen.

15. Assistenzvorrichtung nach Anspruch 14, wobei der Pixelraum durch eine Vielzahl von Pixel mindestens eines Teilbereichs der Ausgabeeinheit (85), insbesondere eines Bildschirms, ausgebildet ist.

16. Assistenzvorrichtung nach Anspruch 14 oder 15, wobei die Eingabeeinheit (83) und die Ausgabeeinheit (85) als eine graphische Nutzerschnittstelle ausgebildet sind, die derart ausgebildet ist, für mindestens einen Parameter ein graphisches Eingabeelement (72, 73) darzustellen und darüber die entsprechenden Parameterwerte auszuwählen und zu empfangen.

17. Computerprogrammprodukt umfassend ein nicht vorübergehendes Computer-lesbares Medium, das direkt in einen Speicher eines digitalen Computers ladbar ist, umfassend Programmcodeteile, die dazu geeignet sind, die Schritte des Verfahrens nach einem der Ansprüche 1 bis 13 durchzuführen.
